# EUROPEAN PATENT APPLICATION

(11) **EP 3 792 689 A1**
(43) Date of publication of application: **17.03.2021**
(21) Application number: 20195015.1
(22) Date of filing: 08.09.2020
(51) Int. Cl.: G03B 21/16

(54) **PROJECTION APPARATUS**

(30) Priority: 12.09.2019 CN 201921520150 U
(71) Applicant: Coretronic Corporation, Hsin-Chu 300 (TW)
(72) Inventor: HSUEH, Hwai Ning, 300 Hsin-Chu (TW); CHIEN, Wei-Min, 300 Hsin-Chu (TW); HOU, Yi-Cheng, 300 Hsin-Chu (TW)
(74) Representative: Ter Meer Steinmeister & Partner

(57) **Abstract**

A projection apparatus including a frame body (130), an optical engine module (110) disposed in the frame body and including at least one light source (112) and a light valve (114), a projection lens (120), and a first heat dissipation module (160). The light source provides an illumination light beam (L1). The light valve located in a transmission path of the illumination light beam converts the illumination light beam into an image light beam (L2). The projection lens located in a transmission path of the image light beam projects the image light beam. The first heat dissipation module is disposed on the frame body and contacts at least one of the light source and the light valve. The frame body and the first heat dissipation module together form at least part of a housing of the projection apparatus. A thermal conductivity coefficient of the frame body is less than that of the first heat dissipation module.

## Description

This application claims priority of CN appl. serial no. 201921520150.x, filed on September 12, 2019.

### BACKGROUND

### Technical Field

The invention relates to an optical apparatus, and more particularly, to a projection apparatus.

### Description of Related Art

Projection apparatuses may be used to project images out of the projection apparatuses. According to the imaging principle of projection apparatuses, an illumination light beam generated by a light source is converted into an image light beam through a light valve, and the image light beam is then projected out of a projection apparatus through a projection lens.

In the development of the projection apparatuses, the projection apparatuses become miniaturized, vehicle-use miniaturized projection apparatuses thereby have gained increasing popularity. A vehicle-use miniaturized projection apparatus may be installed on a suitable position in a vehicle and may be used to project images or texts, such as welcome, bon voyage, etc. and corresponding images on the door, the ground, or other appropriate positions when the door is opened. The vehicle-use miniaturized projection apparatuses may also be used to project dynamic images. Nevertheless, members such as image driving circuit boards are required to be disposed in the vehicle-use miniaturized projection apparatuses, so that projection of the dynamic images requiring complex projection can be achieved. In a vehicle-use miniaturized projection apparatus, members such as the light source, the light valve, and the image driving circuit board may all generate thermal energy. Nevertheless, as the configuration space of the vehicle body is limited, adding a fan for heat dissipation is difficult to be achieved. Therefore, how to allow a projection apparatus to exhibit a favorable heat dissipation capability without a fan in a limited configuration space is an important issue in this field.

The information disclosed in this Background section is only for enhancement of understanding of the background of the described technology and therefore it may contain information that does not form the prior art that is already known to a person of ordinary skill in the art. Further, the information disclosed in the Background section does not mean that one or more problems to be resolved by one or more embodiments of the invention were acknowledged by a person of ordinary skill in the art.

### SUMMARY

The invention provides a projection apparatus exhibiting a favorable heat dissipation capability.

Other features and advantages of the invention are disclosed by the technical features broadly embodied and described as follows.

The object is solved by the features of the independent claims. Preferred embodiments are given in the dependent claims.

In order to achieve one or part of or all of the objects or other objects, an embodiment of the invention provides a projection apparatus including a frame body, an optical engine module, a projection lens, and a first heat dissipation module. The optical engine module is disposed in the frame body and includes at least one light source and a light valve. The at least one light source is configured to provide an illumination light beam. The light valve is located in a transmission path of the illumination light beam and is configured to convert the illumination light beam into an image light beam. The projection lens is located in a transmission path of the image light beam and is configured to project the image light beam. The first heat dissipation module is disposed on the frame body and is in contact with at least one of the at least one light source and the light valve. The frame body and the first heat dissipation module together form at least part of a housing of the projection apparatus. A thermal conductivity coefficient of the frame body is less than a thermal conductivity coefficient of the first heat dissipation module.

To sum up, in the projection apparatus provided by the invention, the housing of the projection apparatus not only includes the frame body having a low thermal conductivity coefficient but also the heat dissipation modules combined with the frame body and having high thermal conductivity coefficients. That is, the housing of the projection apparatus is not entirely formed by a non-heat dissipation material having a low thermal conductivity coefficient but is partially formed by a heat dissipation material having a high thermal conductivity coefficient. In such a configuration, the heat dissipation modules become part of the housing without additionally occupying the configuration space. Moreover, the thermal energy generated by the heat generation devices such as the at least one light source the light valve may be directly dissipated through the heat dissipation modules, and therefore, the projection apparatus may exhibit a favorable heat dissipation capability.

Preferably, the frame body may have a first opening.

Preferably, the first heat dissipation module may cover the first opening.

Preferably, the first heat dissipation module may be located above the optical engine module in a direction of gravity.

Preferably, the first heat dissipation module may comprise a main portion and a bent portion.

Preferably, the main portion may be in contact with the light valve.

Preferably, the bent portion may be in contact with the at least one light source.

Preferably, the projection apparatus may further comprise at least one processing module and at least one second heat dissipation module.

Preferably, the at least one processing module may be disposed in the frame body.

Preferably, the at least one second heat dissipation module may be disposed on the frame body and may be in contact with the at least one processing module, the frame body, the first heat dissipation module, and the at least one second heat dissipation module together form at least part of the housing of the projection apparatus.

Preferably, the thermal conductivity coefficient of the frame body may be less than a thermal conductivity coefficient of the at least one second heat dissipation module.

Preferably, the frame body may have at least one second opening.

Preferably, the at least one second heat dissipation module may cover the at least one second opening.

Preferably, the frame body may have a top surface and at least one side surface connected to the top surface.

Preferably, the first heat dissipation module may be disposed on the top surface.

Preferably, the at least one second heat dissipation module may be disposed on the at least one side surface.

Preferably, the first heat dissipation module may not be in contact with the at least one second heat dissipation module.

Preferably, the at least one processing module may be a power processing module or an image signal processing module.

Preferably, the optical engine module may comprise a light transmissive cover body.

Preferably, the light transmissive cover body may be assembled to the frame body and may cover the optical engine module.

Preferably, the image light beam may be configured to be projected through the light transmissive cover body.

Preferably, the frame body, the first heat dissipation module, and the light transmissive cover body together may form at least part of the housing of the projection apparatus.

Other objectives, features and advantages of the present invention will be further understood from the further technological features disclosed by the embodiments of the present invention wherein there are shown and described preferred embodiments of this invention, simply by way of illustration of modes best suited to carry out the invention.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a schematic view of a projection apparatus according to an embodiment of the invention.
FIG. 2 is a three-dimensional view of the projection apparatus of FIG. 1.
FIG. 3 is a three-dimensional view of part of members of the projection apparatus of FIG. 2.
FIG. 4 is an exploded view of the projection apparatus of FIG. 3.

### DESCRIPTION OF THE EMBODIMENTS

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the present invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the present invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

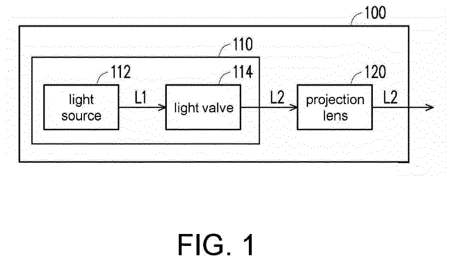

FIG. 1 is a schematic view of a projection apparatus according to an embodiment of the invention. With reference to FIG. 1, a projection apparatus 100 of this embodiment includes an optical engine module 110 and a projection lens 120, and the optical engine module 110 includes at least one light source 112 and a light valve 114. The at least one light source 112 is configured to provide an illumination light beam L1. The light valve 114 is located in a transmission path of the illumination light beam L1 and is configured to convert the illumination light beam L1 into an image light beam L2. The projection lens 120 is located in a transmission path of the image light beam L2 and is configured to project the image light beam L2 out of the projection apparatus. For instance, the at least one light source 112 is a solid-state illumination source such as a light emitting diode or a laser diode and the like. In addition, the light valve 114 is, for example, a reflective or transmissive space light modulator. A reflective space modulator may be exemplified as a liquid crystal on silicon (LCOS) or a digital micro-mirror device (DMD), and the like, and a transmissive space light modulator may be exemplified as a transparent liquid crystal panel. In the invention, a type or a kind of the light valve 114 is not limited. The projection lens 120 is formed by a plurality of lenses and is configured to transmit the image light beam L2.

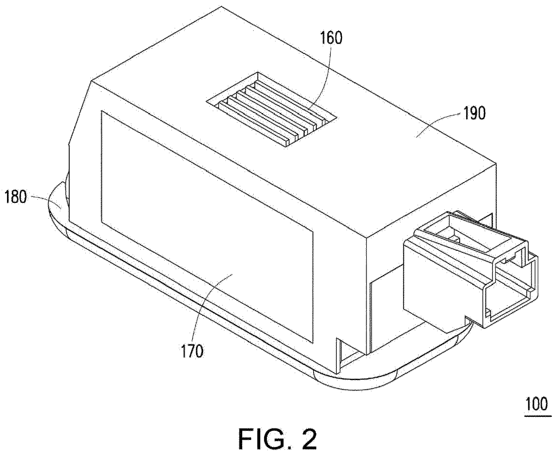

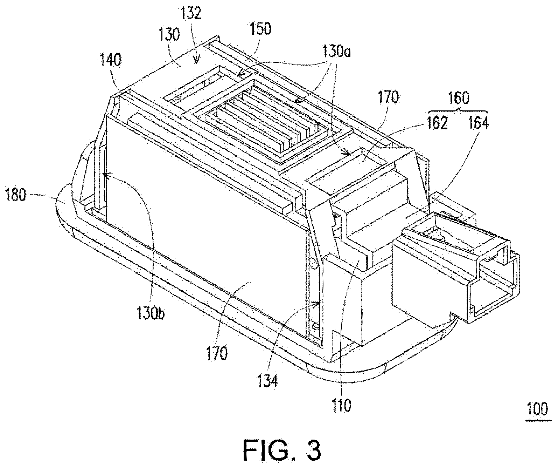

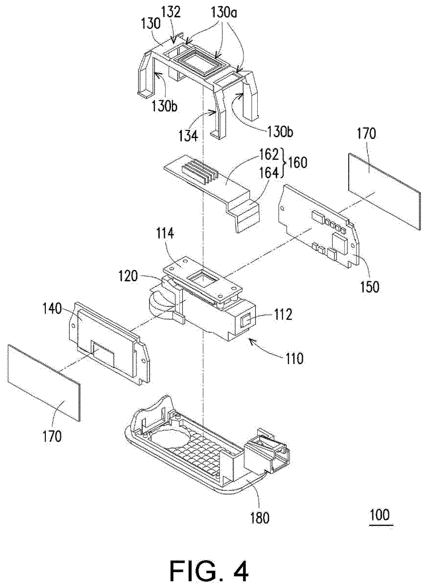

FIG. 2 is a three-dimensional view of the projection apparatus of FIG. 1. FIG. 3 is a three-dimensional view of part of members of the projection apparatus of FIG. 2. FIG. 4 is an exploded view of the projection apparatus of FIG. 3. With reference to FIG. 2 to FIG. 4, in this embodiment, the projection apparatus 100 further includes a frame body 130, a first processing module 140, a second processing module 150, a first heat dissipation module 160, two second heat dissipation modules 170, and a light transmissive cover body 180. The optical engine module 110, the first processing module 140, and the second processing module 150 are disposed in the frame body 130. The first processing module 140 and the second processing module 150 respectively are, for example, a power processing module and an image signal processing module, for example. A power processing module is a circuit, a circuit module, or a chip configured to receive power and is configured to distribute/adjust and transmit power to electronic devices that need power to operate in projection apparatus 100. The image signal processing module is, for example, a central processing unit (CPU) or a programmable microprocessor for general or special use, a digital signal processor (DSP), a programmable controller, an application specific integrated circuit (ASIC), a programmable logic device (PLD), or other similar devices or a combination of the foregoing devices.

In addition, the light transmissive cover body 180 is assembled to the frame body 130 and covers the optical engine module 110. The image light beam L2 (shown in FIG.1) is configured to be projected through an opening of the light transmissive cover body 180 from the projection lens 120.

The frame body 130 has a top surface 132 and side surfaces 134 connected to the top surface 132. The first heat dissipation module 160 is disposed on the top surface 132 of the frame body 130 and is in contact with the at least one light source 112 and the light valve 114, so as to dissipate heat generated by the at least one light source 112 and the light valve 114. The two second heat dissipation modules 170 are disposed on the side surfaces 134 of the frame body 130 and are in contact with the first processing module 140 and the second processing module 150 respectively, so as to dissipation heat generated by the first processing module 140 and the second processing module 150. The frame body 130, the first heat dissipation module 160, the second heat dissipation modules 170, and the light transmissive cover body 180 together form at least part of a housing of the projection apparatus 100. Thermal conductivity coefficients of the frame body 130 and the light transmissive cover body 180 are less than thermal conductivity coefficients of the first heat dissipation module 160 and the second heat dissipation modules 170. Specifically, materials of the frame body 130 and the light transmissive cover body 180 are, for example, plastic or other materials having low thermal conductivity coefficients, and materials of the first heat dissipation module 160 and the second heat dissipation modules 170 are, for example, metal or other materials having high thermal conductivity coefficients. The projection apparatus 100 may further include a hood body 190 as shown in FIG. 2. The hood body 190 hoods the optical engine module 110, the frame body 130, the first processing module 140, the second processing module 150, the first heat dissipation module 160, and the second heat dissipation modules 170. The hood body 190 exposes at least part of first heat dissipation module 160 and the second heat dissipation modules 170, and in this way, thermal energy of the first heat dissipation module 160 and the second heat dissipation modules 170 may be dissipated to an outside of the projection apparatus 100 through natural convection.

As described above, besides the frame body 130 and the light transmissive cover body 180 having low thermal conductivity coefficients, the housing of the projection apparatus 100 also includes the first heat dissipation module 160 and the second heat dissipation modules 170 combined with the frame body 130 and having high thermal conductivity coefficients. That is, the housing of the projection apparatus 100 is not entirely formed by non-heat dissipation materials having low thermal conductivity coefficients. Instead, heat dissipation materials having high thermal conductivity coefficients partially form the housing of the projection apparatus 100. In such a configuration, the first heat dissipation module 160 and the second heat dissipation modules 170 become part of the housing without additionally occupying a configuration space. Further, thermal energy generated by the heat generation devices such as the at least one light source 112, the light valve 114, the first processing module 140, and the second processing module 150 may be directly dissipated through the first heat dissipation module 160 and the second heat dissipation modules 170, and the projection apparatus 100 thereby exhibits a favorable heat dissipation capability.

In this embodiment, the first heat dissipation module 160 acts as a main heat dissipation module and is configured to dissipate heat generated by a main thermal source, that is, the at least one light source 112 and the light valve 114. In order to allow thermal energy received by the first heat dissipation module 160 from the at least one light source 112 and the light valve 114 to be effectively transmitted and dissipated, the first heat dissipation module 160 is disposed above the optical engine module 110 in a direction of gravity. In this way, the thermal energy received by the first heat dissipation module 160 may be quickly taken away by air above the projection apparatus 100 through natural convection, and the cold air below is accordingly driven to flow along the first heat dissipation module 160 and the second heat dissipation modules 170, so that heat dissipation efficiency is improved. In addition, in this embodiment, a projection direction of the image light beam L2 projected by the projection lens 120 and passing through the light transmissive cover body 180 is the direction of gravity.

Forms of the first heat dissipation modules 160 and the second heat dissipation modules 170 shown in FIG. 2 to FIG. 4 are merely schematic. The first heat dissipation module 160 of this embodiment may be a heat dissipation fin group, a heat pipe, or a combination of the forgoing, may include a heat conduction medium such as thermal grease or a heat dissipating plate, and is in contact with the at least one light source 112 and the light valve 114 through the heat conduction medium. Similarly, the second heat dissipation modules 170 of this embodiment may be heat dissipation fins, heat pipes, heat dissipation metal, or a combination of the forgoing, may include a heat conduction medium such as thermal grease or a heat dissipating plate, and are in contact with the processing modules 140 and 150 through the heat conduction medium.

With reference to FIG. 3 and FIG. 4, specifically, the frame body 130 of this embodiment has at least one first opening 130a (plural first openings are shown) and two second openings 130b. The first heat dissipation module 160 is disposed at an inner side of the frame body 130, covers the at least one first opening 130a, and is exposed by the at least one first opening 130a. The first processing module 140, the second processing module 150, and the two second heat dissipation modules 170 are disposed at an outer side of the frame body 130 and respectively cover the two second openings 130b. The first processing module 140 and the second processing module 150 are individually connected to the optical engine module 110. In addition, the first heat dissipation module 160 includes a main portion 162 and a bent portion 164. The main portion 162 is in contact with the light valve 114 on a top end of the optical engine module 110, and the bent portion 164 extends to a side end of the optical engine module 110 to be in contact with the at least one light source 112.

In this embodiment, note that the first heat dissipation module 160 is not in contact with the second heat dissipation modules 170, and in this way, thermal conductivity is prevented from being generated therebetween, and that heat dissipation effects of the first heat dissipation module 160 and the second heat dissipation modules 170 are prevented from affecting each other. In addition, the two second heat dissipation modules 170 are not in contact with each other, either. In this way, thermal conductivity is prevented from being generated therebetween, and that heat dissipation effects of the two second heat dissipation modules 170 are prevented from affecting each other. In addition, in other embodiments, plural heat dissipation modules may be disposed at any side of the frame body 130 to correspond to a single or plural thermal sources, and the heat dissipation modules located at any two adjacent sides of the frame body 130 may be connected and form into a bent structure. Alternatively, the heat dissipation modules may form into an arc structure or a ring structure and surround around the frame body.

If the projection apparatus 100 is a vehicle-use miniaturized projection apparatus and is configured to be mounted on a vehicle door, at least one of the first heat dissipation module 160 and the second heat dissipation modules 170 of the projection apparatus 100 may be designed to be integrally connected to sheet metal of the vehicle door. In this way, thermal energy may be directly transmitted to the sheet metal of the vehicle door, so that heat the dissipation capability of the projection apparatus 100 is further improved.

In view of the foregoing, in the projection apparatus provided by the invention, the housing of the projection apparatus not only includes the frame body having a low thermal conductivity coefficient but also the heat dissipation modules combined with the frame body and having high thermal conductivity coefficients. That is, the housing of the projection apparatus is not entirely formed by a non-heat dissipation material having a low thermal conductivity coefficient but is partially formed by a heat dissipation material having a high thermal conductivity coefficient. In such a configuration, the heat dissipation modules become part of the housing without additionally occupying the configuration space. Moreover, the thermal energy generated by the heat generation devices such as the at least one light source the light valve may be directly dissipated through the heat dissipation modules, and therefore, the projection apparatus may still exhibit a favorable heat dissipation capability without a fan.

The foregoing description of the preferred embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to particularly preferred exemplary embodiments of the invention does not imply a limitation on the invention, and no such limitation is to be inferred. The invention is limited only by the scope of the appended claims. Moreover, these claims may refer to use "first", "second", etc. following with noun or element. Such terms should be understood as a nomenclature and should not be construed as giving the limitation on the number of the elements modified by such nomenclature unless specific number has been given. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret or limit the scope or meaning of the claims. Any advantages and benefits described may not apply to all embodiments of the invention. It should be appreciated that variations may be made in the embodiments described by persons skilled in the art without departing from the scope of the present invention as defined by the following claims. Moreover, no element and component in the present disclosure is intended to be dedicated to the public regardless of whether the element or component is explicitly recited in the following claims

## Claims

1. A projection apparatus comprising: a frame body (130), an optical engine module (110), a projection lens (120), and a first heat dissipation module (160), wherein
the optical engine module (110) is disposed in the frame body (130) and comprises at least one light source (112) and a light valve (114), wherein the at least one light source (112) is configured to provide an illumination light beam (L1), and the light valve (114) is located in a transmission path of the illumination light beam (L1) and is configured to convert the illumination light beam (L1) into an image light beam (L2),
the projection lens (120) is located in a transmission path of the image light beam (L2) and is configured to project the image light beam (L2), and
the first heat dissipation module (160) is disposed on the frame body (130) and is in contact with at least one of the at least one light source (112) and the light valve (114), wherein the frame body (130) and the first heat dissipation module (160) together form at least part of a housing of the projection apparatus (100), and a thermal conductivity coefficient of the frame body (130) is less than a thermal conductivity coefficient of the first heat dissipation module (160).

2. The projection apparatus as claimed in claim 1, wherein the frame body (130) has a first opening (130a), and the first heat dissipation module (160) covers the first opening (130a).

3. The projection apparatus as claimed in claim 1 or 2, wherein the first heat dissipation module (160) is located above the optical engine module (110) in a direction of gravity.

4. The projection apparatus as claimed in any one of claim 1, 2 or 3, wherein the first heat dissipation module (160) comprises a main portion (162) and a bent portion (164), the main portion (162) is in contact with the light valve (114), and the bent portion (164) is in contact with the at least one light source (112).

5. The projection apparatus as claimed in any one of the preceding claims, further comprising at least one processing module (140, 150) and at least one second heat dissipation module (170).

6. The projection apparatus as claimed in claim 5, wherein the at least one processing module (140, 150) is disposed in the frame body (130), the at least one second heat dissipation module (170) is disposed on the frame body (130) and is in contact with the at least one processing module (140, 150), the frame body (130), the first heat dissipation module (160), and the at least one second heat dissipation module (170) together form at least part of the housing of the projection apparatus (100), and the thermal conductivity coefficient of the frame body (130) is less than a thermal conductivity coefficient of the at least one second heat dissipation module (170).

7. The projection apparatus as claimed in claim 5 or 6, wherein the frame body (130) has at least one second opening (130b), and the at least one second heat dissipation module (170) covers the at least one second opening (130b).

8. The projection apparatus as claimed in claim 5, 6 or 7, wherein the frame body (130) has a top surface (132) and at least one side surface (134) connected to the top surface (132), the first heat dissipation module (160) is disposed on the top surface (132), and the at least one second heat dissipation module (170) is disposed on the at least one side surface (134).

9. The projection apparatus as claimed in claim 5, 6, 7 or 8, wherein the first heat dissipation module (170) is not in contact with the at least one second heat dissipation module (170).

10. The projection apparatus as claimed in claim 5, 6, 7, 8 or 9, wherein the at least one processing module (140, 150) is a power processing module or an image signal processing module.

11. The projection apparatus as claimed in any one of the preceding claims, wherein the optical engine module (110) comprises a light transmissive cover body (180).

12. The projection apparatus as claimed in claim 11, wherein the light transmissive cover body (180) is assembled to the frame body (130) and covers the optical engine module (110), and the image light beam (L2) is configured to be projected through the light transmissive cover body (180).

13. The projection apparatus as claimed in claim 11 or 12, wherein the frame body (130), the first heat dissipation module (160), and the light transmissive cover body (180) together form at least part of the housing of the projection apparatus (100).
